# EUROPEAN PATENT APPLICATION

(11) **EP 4 657 678 A1**
(43) Date of publication of application: **03.12.2025**
(21) Application number: 25177536.7
(22) Date of filing: 20.05.2025
(51) Int. Cl.: H01S 3/063, H01S 3/0941, H01S 3/16, H01S 3/00, H01S 5/0234, H01S 5/0237, H01S 3/17, H01S 5/02

(54) **INTEGRATION OF ERBIUM-DOPED LOW LOSS SILICON NITRIDE WAVEGUIDES ON SILICON PHOTONICS**

(30) Priority: 24.05.2024 US 202418673888
(71) Applicant: Cisco Technology, Inc., San Jose, CA 95134-1706 (US)
(72) Inventor: Chen, Li, Maynard, MA (US); Chen, Long, Maynard, MA (US)
(74) Representative: Noble, Nicholas

(57) **Abstract**

**In** various embodiments, the disclosure relates to an electro-optical device that includes an optical amplifier and a photonic assembly. The optical amplifier may include a first encapsulation layer defining a first bonding surface, and an erbium-doped Si3N4 waveguide, wherein the erbium-doped Si₃N₄ waveguide disposed within the first encapsulation layer. The photonic assembly may include a substrate, a second encapsulation layer defining a second bonding surface, the second encapsulation layer disposed on the substrate, a modulator, one or more photodetectors, and a waveguide. **In** various embodiments, the modulator, the one or more photodetectors and the waveguide are disposed within the second encapsulation layer. The one or more regions of the first bonding surface are bonded to the one or more regions of the second bonding surface in various embodiments. The Si₃N₄ waveguide is optically coupled to the waveguide in various embodiments.

## Description

### FIELD

This disclosure relates generally to the field of silicon photonic waveguide amplifiers.

### BACKGROUND

Contemporary optical communications and other photonic systems make extensive use of photonic integrated circuits that are advantageously mass-produced in various configurations for various purposes.

### BRIEF DESCRIPTION OF THE FIGURES

Unless specified otherwise, the accompanying drawings illustrate aspects of the innovations described herein. Referring to the drawings, wherein like numerals refer to like parts throughout the several views and this specification, several embodiments of presently disclosed principles are illustrated by way of example, and not by way of limitation. The drawings are not intended to be to scale. A more complete understanding of the disclosure may be realized by reference to the accompanying drawings in which:
Figure 1 is a cross-sectional diagram of a silicon photonic wafer with an integrated erbium-doped Si₃N₄ waveguide amplifier and pump laser according to an exemplary embodiment of the disclosure.
Figures 2A-2D are cross-sectional diagrams of processing stages or steps of fabricating or integrating an erbium-doped Si₃N₄ waveguide amplifier on a silicon photonic wafer according to an exemplary embodiment of the disclosure.
Figures 3A-3D are cross-sectional diagrams processing stages or steps of fabricating or integrating an erbium-doped Si₃N₄ waveguide amplifier on a silicon photonic wafer according to an exemplary embodiment of the disclosure.
Figures 4A-4C are schematic diagrams showing exemplary structures for the wafer that contains the erbium-doped Si₃N₄ waveguide amplifier according to an exemplary embodiment of the disclosure.
Figures 5A-5D are schematic diagrams showing exemplary structures of the silicon photonic wafer prior to integration of the erbium-doped Si₃N₄ waveguide amplifier according to an exemplary embodiment of the disclosure.
Figure 6 is a schematic diagram of a silicon photonic coherent transmitter with an integrated Er-doped Si₃N₄ waveguide amplifier according to an exemplary embodiment of the disclosure.

### OVERVIEW

In part, the disclosure relates to an electro-optical device that includes an optical amplifier and a photonic assembly. The optical amplifier may include a first encapsulation layer defining a first bonding surface, and an erbium-doped Si₃N₄ waveguide, wherein the erbium-doped Si₃N₄ waveguide disposed within the first encapsulation layer. The photonic assembly may include a substrate, a second encapsulation layer defining a second bonding surface, the second encapsulation layer disposed on the substrate, a modulator, one or more photodetectors, and a waveguide. In various embodiments, the modulator, the one or more photodetectors and the waveguide are disposed within the second encapsulation layer. The one or more regions of the first bonding surface are bonded to the one or more regions of the second bonding surface in various embodiments. The Si₃N₄ waveguide is optically coupled to the waveguide in various embodiments.

### EXEMPLARY EMBODIMENTS

Silicon photonics may contain optical interconnects with a limited power budget. Optical gain may be introduced either on-chip or off-chip to achieve the desired output power. Various optical components require improved optical gain, such as optical transceivers for longhaul and short-reach applications, board-to-board, chip-to-chip or on-chip optical interconnects links for high-speed computing, and large-scale on-chip optical switching fabrics. An external erbium-doped fiber amplifier (EDFA) or an integrated semiconductor optical amplifier (SOA) may be utilized to obtain sufficient optical gain within a limited power budget. However, implementations of EDFAs are large and expensive. Similarly, SOAs may introduce nonlinear distortions to the amplified signal and generate heat leading to instability or requiring the implementation of cooling systems. Therefore, it is desirable to implement an erbium-doped waveguide amplifier (EDWA) which includes an erbium-doped dielectric waveguide on a substrate.

The host material of the erbium-doped dielectrics may include aluminum oxide (Al₂O₃), tantalum pentoxide (Ta₂O₅), tellurium dioxide (TeO₂), lithium niobate (LiNbO₃), silicate, and silicon nitride (Si₃N₄). In various embodiments, Si₃N₄ is desirable due to its wider transparency window, ultra-low two-photon absorption effect at telecommunications wavelengths, and low propagation losses on the order of a few dB/m. An ultra-low waveguide background loss allows for longer waveguide amplifier without depleting the pump power, and higher on chip net gain and output power that are comparable to a commercial EDFA. To achieve low loss Si₃N₄ waveguides requires thermal annealing at elevated temperatures (1050 to 1200°C) for a few hours, which improves the material impurity of both Si₃N₄ and its silicon dioxide (SiO₂) cladding.

It is challenging to monolithically integrate erbium-doped Si₃N₄ into a Complementary Metal Oxide Semiconductor (CMOS) silicon photonic wafer. For example, high temperature annealing for an extended duration to reduce the Si₃N₄ loss and activate the dopant is over the thermal budget of the back end of line of the CMOS process. Such high temperatures would destroy the metallization and active silicon photonic device (e.g., modulators and/or photodetectors). Further, erbium is a contaminant for the CMOS front end. As a result, the erbium doping process may not be processed in the same CMOS fabrication.

In various embodiments, integration of erbium-doped Si₃N₄ waveguide amplifier on the silicon photonics is achieved by heterogeneously integrating a wafer containing an erbium-doped Si₃N₃ waveguide amplifier and a silicon photonic wafer. The integration of the two wafers may be achieved by wafer bonding and substrate removal or other mechanisms of adhering or coupling wafer regions or portions. In many embodiments, the disclosure relates to the heterogeneous integration, coupling, adhering, joining, and/or connecting of semiconductor layers and regions to integrate a waveguide amplifier with other silicon photonic elements such as a laser and photodiodes.

In many embodiments, an encapsulated erbium doped Si₃N₄ waveguide amplifier is integrated with other photonic multi-component semiconductor-based devices. The heterogeneous approach separates the Er-doped Si₃N₄ waveguide process and the silicon photonic wafer process. In most embodiments, the Er-doped Si₃N₄ can be annealed at elevated temperature such separately to achieve low background loss and dopant activation without impacting the silicon photonic circuit. Further, in various embodiments, the
doped waveguide is encapsulated by SiO₂ cladding which in turn reduces the risk of erbium contamination. Similarly, in various embodiments, un-doped low-loss Si₃N₄ waveguides can be integrated with the same process, to support low-loss silicon nitride photonic devices.

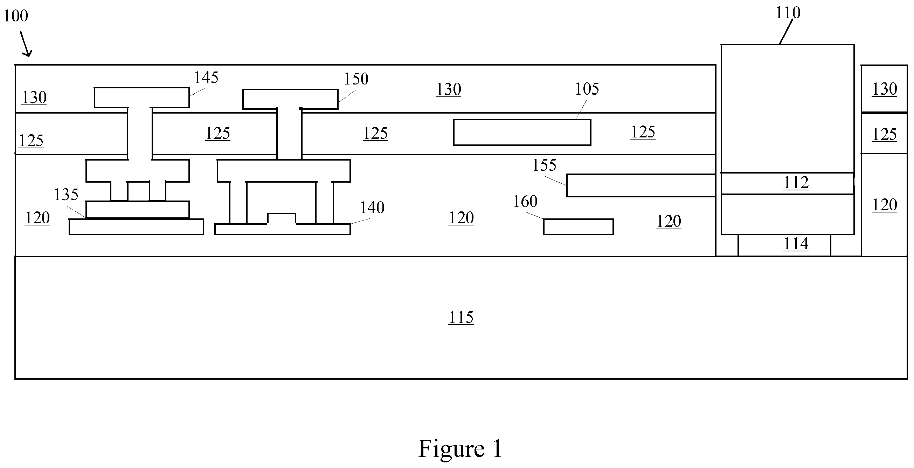

Refer now to the example embodiment of Figure 1. Figure 1 depicts a silicon photonic wafer 100 with an integrated erbium-doped Si₃N₄ waveguide amplifier 105, a pump laser 110, a substrate 115, layers or regions comprising SiO₂ or another cladding or encapsulation material regions 120, 125, 130. The pump laser 110 may include a light transmitting portion 112 that is in optical communication with Si₃N₄ waveguide 155. The pump laser may also include one or more metal contacts 114 for electrical control. The silicon photonic wafer 100 may also include metallized active photonic devices, e.g., a photodetector 135 and modulator 140 with an electrode material such as a metal 145, 150, a Si₃N₄ waveguide 155 and a silicon waveguide 160. The photodetector 135 may be a germanium detector and the modulator 140 may be a silicon modulator. In various embodiments, the photodetector includes one or more photodiodes. In various embodiments the photodetector includes one or more germanium photodiodes. In various embodiments the photodetector 135 and modulator 140 act as part of a transceiver.

In various embodiments, the erbium-doped Si₃N₄ waveguide amplifier 105 is heterogeneously integrated by wafer bonding and substrate removal. The erbium-doped Si₃N₄ waveguide amplifier 105 may be annealed at elevated temperatures (800°C to 1200°C) separate from the other elements of the silicon photonic wafer 100 to achieve low background loss and dopant activation without impacting the silicon photonic wafer 100 and circuit. The erbium-doped Si₃N₄ waveguide amplifier 105 may be encapsulated in in a SiO₂ region 125 as cladding which is similarly heterogeneously integrated into the silicon photonic wafer 100. The SiO₂ region 125 may be used as cladding to reduce the risk of erbium contamination.

The Si₃N₄ waveguide 155 may be optically coupled to the silicon waveguide 160 and erbium-doped Si₃N₄ waveguide amplifier 105 with waveguide couplers. Further, the Si₃N₄ waveguide may be aligned with and optically coupled to the pump laser 110. The pump laser 110 may be flip-chip bonded into a trench of the silicon photonic wafer 100. The pump laser 110 is flip-chip bonded to provide electrical contact with the silicon photonic wafer 100 and aligned with the Si₃N₄ waveguide 155. The pump laser 110 provides high optical gain and high saturation output from the silicon photonic wafer 100.

In some embodiments, the Si₃N₄ waveguide 155 is used to optically couple three different components or functionalities such as one or more of the silicon waveguide 160 for the modulated optical signal of a modulator, the pump laser waveguide for the pump laser 110, and the erbium-doped Si₃N₄ waveguide amplifier 105. In some embodiments, the Si₃N₄ waveguide 155 is also used to optically couple the output of the erbium-doped Si₃N₄ waveguide amplifier 105 to the photodetector 135 for optical power monitoring. In various embodiments, optical coupling can be implemented as direct end-fire butt coupling. In some embodiments, optical coupling can be implemented as adiabatic vertical coupling.

In some embodiments, the silicon photonic wafer 100 may include a wavelengthdivision multiplexer that combines the modulated optical signal and the pump light before the erbium-doped waveguide amplifier. In some embodiments, such a multiplexer may be built on the Si₃N₄ waveguide 155, or the Si₃N₄ waveguide amplifier 105, or the combination of both Si₃N₄ waveguide 155 and Si₃N₄ waveguide amplifier 105, or other waveguide layers.

In some embodiments, the silicon photonic wafer 100 may also include a wavelength-stabilization device for the pump laser. In some embodiments, the wavelength-stabilization device may include a wavelength-selective partial reflector and appropriate optical delay element between the reflector and the pump laser. The wavelength-selective partial reflector provides optical feedback to the pump laser with respect to a wavelength target and is configured such that the optical wavelength and output power of the pump laser are stable against variations such as temperature.

For example, the wavelength-selective partial reflector can be a Bragg reflector in some embodiments. The center wavelength of the Bragg may be about 980 nm or about 1480 nm, two spectral regions associated with erbium absorption and used for pump lasers. The bandwidth of the Bragg may be in the range of about 0.2 nm to about 2 nm. The delay length between the Bragg and the pump laser may be in the range of about 1 mm to about 1 m. In various embodiments, the wavelength-stabilization device may be built on the Si₃N₄ waveguide 155, or the Si₃N₄ waveguide amplifier 105, or the combination of both Si₃N₄ waveguide 155 and Si₃N₄ waveguide amplifier 105, or other waveguide layers.

In various embodiments, the Si₃N₄ waveguide 155 is optional, and some or all of its functions or operations disclosed herein can be implemented using the Si₃N₄ waveguide amplifier 105. For example, the pump laser 110 can be directly optically coupled to Si₃N₄ waveguide amplifier 105. The Si₃N₄ waveguide amplifier 105 can also be directly optically coupled to the silicon waveguide 160 in connection to the silicon modulator or the germanium photodiode. However, having the Si₃N₄ waveguide 155 and separating the functions from the Si₃N₄ waveguide amplifier 105 may allow separate optimization in those functions separate from or independent from the optimization for the erbium-doped waveguide amplifier.

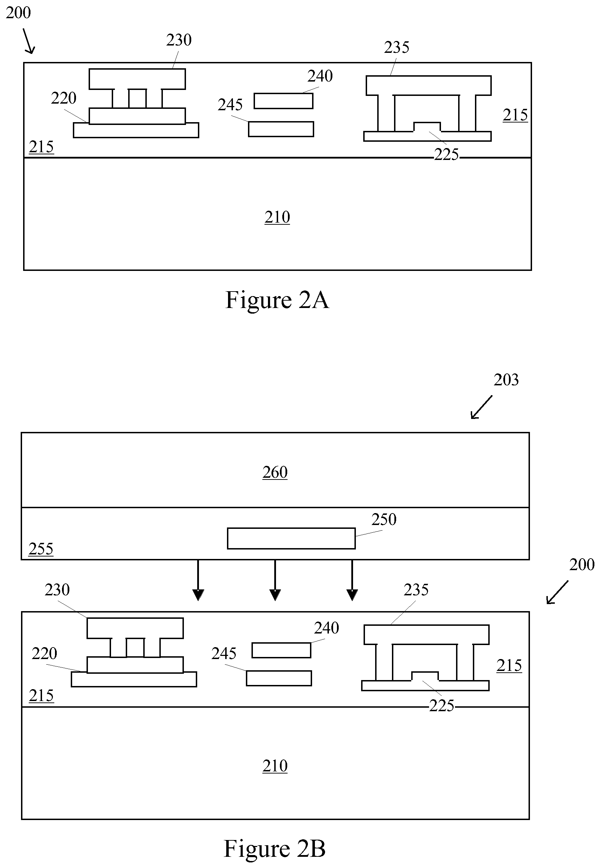

Refer to the example embodiment of Figures 2A-2D. Figures 2A-2D depict an example integration of an erbium-doped Si₃N₄ waveguide amplifier on a silicon photonic wafer. In Figure 2A, a base wafer 200 is provided. The base wafer 200 may include a substrate 210, a SiO₂ region 215, a detector 220 and a modulator 225 with metal contacts 230, 235, a Si₃N₄ waveguide 240, and a silicon waveguide 245. An additional semiconductor layer 265 may surround some of the metal contacts or portions thereof in some embodiments. In various embodiments, the base wafer 200 is a silicon photonic base wafer.

In Figure 2B a second wafer 203 is provided, the second wafer 203 including an erbium-doped Si₃N₄ waveguide amplifier 250 and SiO₂ cladding 255 on a second silicon substrate 260. The second wafer 203 is fabricated separately from the base wafer 200 and may be flip bonded to the base wafer 200 to form a silicon photonic wafer in accordance with the present disclosure. The second wafer 203 may be bonded and annealed to the base wafer 200 using oxide-to-oxide direct bonding. The bonding and annealing may be performed at a temperature of less than 400°C. There may be alignment marks on both wafers to allow for alignment accuracy within 100 nm. Prior to bonding, surface cleaning and activation with plasma may occur. In various embodiments stress balancing thin films such as Si₃N₄ thin films may be deposited on the backside of the wafers prior to wafer bonding to reduce the wafer bow.

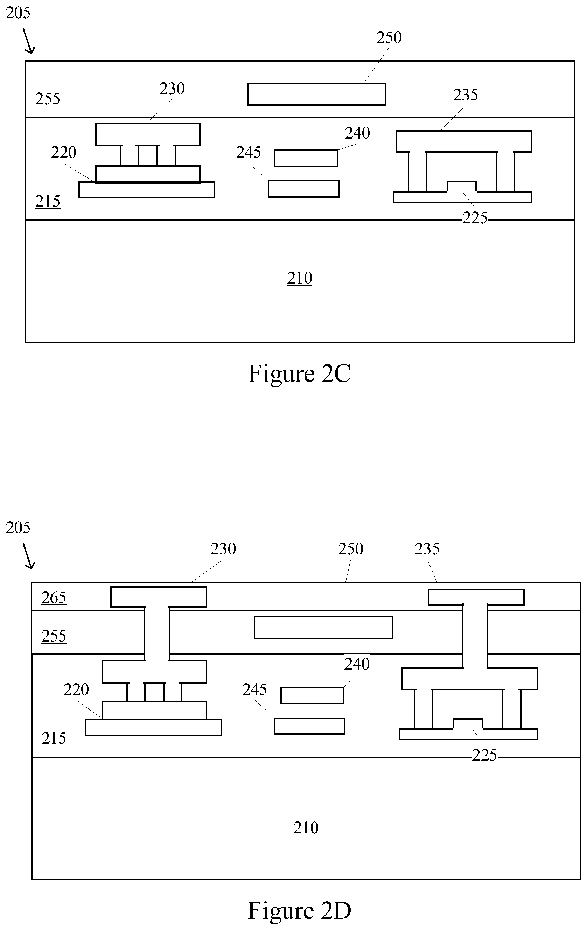

In Figure 2C an erbium-doped Si₃N₄ waveguide amplifier 250 and the SiO₂ cladding 255 and base wafer 200 have been integrated into the silicon photonic wafer 205 and the second silicon substrate 260 of the second wafer 203 has been removed. The second silicon substrate 260 may be removed by mechanical grinding and reactive-ion or chemical etching. In various embodiments the mechanical grinding may include dry etching or wet etching. In some embodiments, the erbium-doped Si₃N₄ waveguide amplifier is encapsulated by SiO₂.

In Figure 2D depicts the silicon photonic wafer 205 after additional backend processes have been applied. For example, an additional region of SiO₂ 265 may be deposited to the silicon photonic wafer 205, and the metal contacts 230, 235 may be extended into the additional region of SiO₂ 265. After integration of the erbium-doped Si₃N₄ waveguide amplifier 250, light may couple between the silicon waveguide 245 or Si₃N₄ waveguide 240 and the erbium-doped Si₃N₄ waveguide amplifier 250 with waveguide couplers.

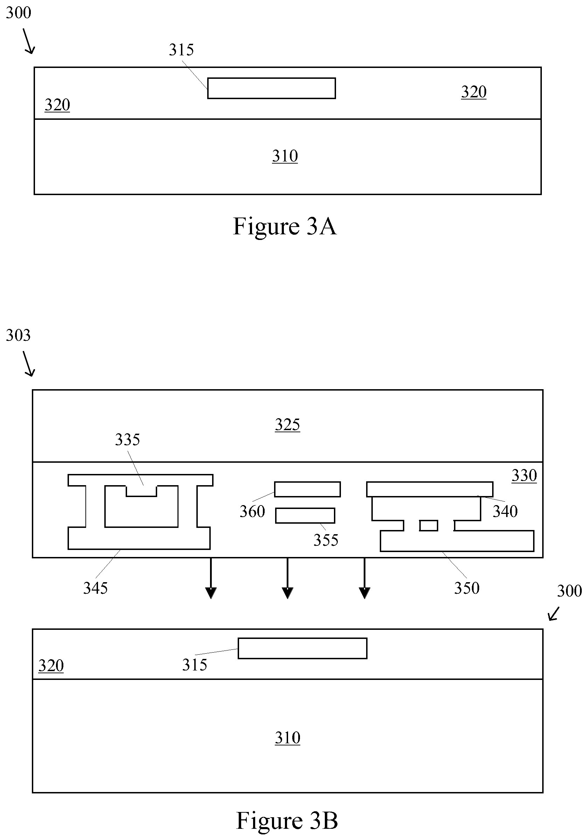

Refer to the example embodiment of Figures 3A-3D. Figures 3A-3D depict an alternative integration of an erbium-doped Si₃N₄ waveguide amplifier into a silicon photonic wafer. In Figure 3A a base wafer 300 is provided. The base wafer 300 includes a silicon substrate 310, an erbium-doped Si₃N₄ waveguide amplifier 315, and SiO₂ cladding 320 that encapsulates the erbium-doped Si₃N₄ waveguide amplifier 315. In some embodiments, the erbium-doped Si₃N₄ base wafer and silicon photonic wafer are bonded using oxide-to-oxide direct bonding.

In Figure 3B a second wafer 303 is provided. The second wafer 303 may include a second substrate 325, a SiO₂ region 330, a modulator 335, a detector 340, metal contacts 345, 350, a Si₃N₄ waveguide 355, and a silicon waveguide 360. The second wafer 303 is configured to be flip bonded to the base wafer 300 to form a silicon photonic wafer in accordance with the present disclosure. The second wafer 303 may be bonded and annealed to the base wafer 300 using various bonding methods. In some embodiments, oxide-to-oxide direct bonding may be used. The bonding and annealing may be performed at a temperature of less than 400°C. There may be alignment marks on both wafers to allow for alignment accuracy within 100 nm. Prior to bonding, surface cleaning and activation with plasma may occur. In various embodiments stress balancing thin films such as silicon nitride may be deposited on the backside of the wafers prior to wafer bonding to reduce the wafer bow.

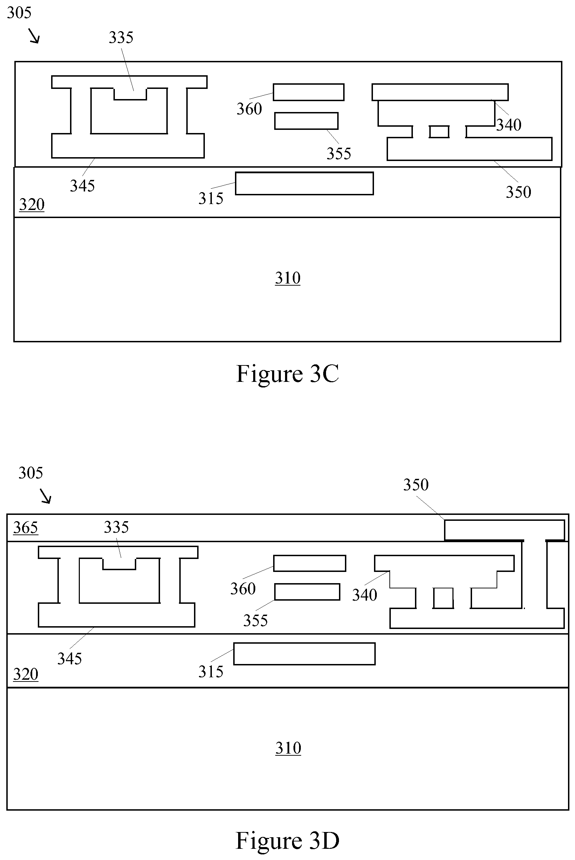

In Figure 3C the second wafer 303 and base wafer 300 have been integrated into a silicon photonic wafer 305 and the second substrate 325 of the second wafer 303 has been removed. The second substrate 325 may be removed by mechanical grinding and reactive-ion or chemical etching. In various embodiments the mechanical grinding may include dry etching or wet etching.

In Figure 3D depicts the silicon photonic wafer 305 after additional backend processes have been applied. For example, an additional region of SiO₂ 365 may be deposited to the silicon photonic wafer 305, and the metal contact 350 may be extended into the additional region of SiO₂ 365. After integration of the erbium-doped Si₃N₄ waveguide amplifier 315, light may couple between the silicon waveguide 360 or Si₃N₄ waveguide 355 and the erbium-doped Si₃N₄ waveguide amplifier 315 with waveguide couplers. An additional semiconductor layer 365 may surround some of the metal contacts or portions thereof in some embodiments.

In both example integrations Figures 2A-2D and Figures 3A-3D, the wafer containing the erbium-doped Si₃N₄ waveguide amplifier (in Figure 2A-2D, the second wafer 203, and in Figure 3A - 3D, the base wafer) may be fabricated separately from the remaining optical components of the silicon photonic wafer, which may be fabricated by a CMOS silicon photonic foundry. The wafer containing erbium-doped Si₃N₄ waveguide amplifier may be manufactured by a foundry with a dedicated line that allows direct erbium contact in the foundry tools. The erbium-doped Si₃N₄ waveguide amplifier may be encapsulated in SiO₂ cladding. As the backend process does not require high temperature annealing, the risk of erbium diffusion and contamination can be minimized. As a result, the heterogenous integration process may be performed by a standard CMOS silicon photonic foundry.

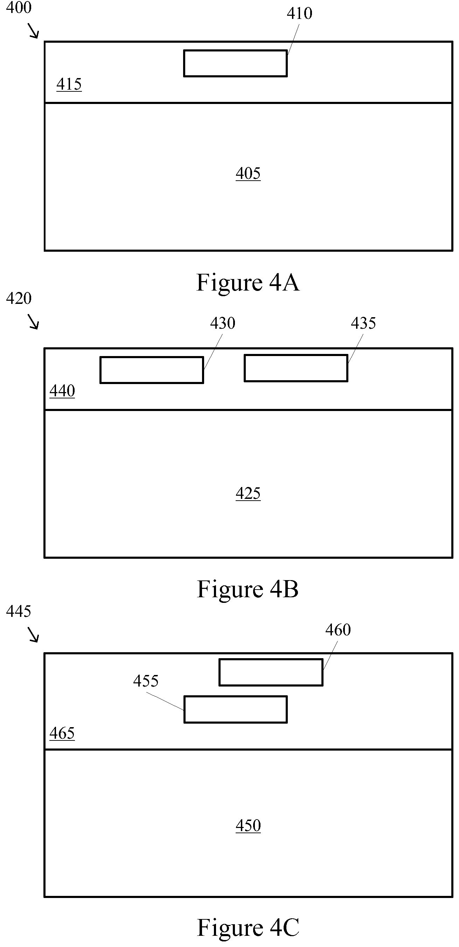

Refer now to the example embodiments Figures 4A-4C. Figures 4A-4C show example structures for the wafer that contains the erbium-doped Si₃N₄ waveguide amplifier. For example, Figure 4A depicts a wafer 400 with a substrate 405 and a single layer erbium-doped Si₃N₄ waveguide amplifier 410 clad in a SiO₂ region 415. In various embodiments and as depicted in Figure 4B, a wafer 420 may include a substrate 425, an erbium-doped Si₃N₄ waveguide amplifier 430, and an Si₃N₄ waveguide 435, clad in a SiO₂ region 440. The Si₃N₄ waveguide 435 may be undoped or selectively doped by ion implantation on selective areas using a photoresist mask. Further, multiple ion implantations with multiple different depths may be performed to achieve a uniform doping profile. In various embodiments and as depicted in Figure 4C, a wafer 445 with a substrate 450, and an erbium-doped Si₃N₄ waveguide amplifier having multiple layers 455, 460 clad in a SiO₂ region 465. One or more of the erbium-doped Si₃N₄ waveguide amplifier layers 455, 460 may include optional doping, like for example, Si₃N₄ layer.

Various other elements may be implemented in designing the erbium-doped Si₃N₄ waveguide amplifier and surrounding structures. In various embodiments, the substrates of the present disclosure may be a bare silicon, an oxidized silicon, or a silicon-on-insulator substrate. The Si₃N₄ thin film of the erbium-doped Si₃N₄ waveguide amplifiers and waveguides may be deposited by either low pressure chemical vapor deposition (LPCVD) or plasma enhanced chemical vapor deposition (PECVD) process. The Si₃N₄ thin film thickness may range from as small as about 100 nm to over about 1 µm. The wafers may be annealed at a temperature between 800°C and 1,200°C for hours before and after the doping process.

In various embodiments, the Si₃N₄ waveguides can be patterned by photolithography and etching, or by a photonic damascene process in which Si₃N₄ is filled into and polished over predefined trenches in the SiO₂. The width of the Si₃N₄ waveguides are on the order of about 500 nm to over about 3 µm. The Si₃N₄ waveguides may be formed into spirals to reduce footprint. Alignment markers for wafer bonding can be formed when the Si₃N₄ waveguide is patterned. The annealing process can be performed before or after the patterning of the Si₃N₄ waveguides. To improve wafer bonding alignment accuracy, additional metal markers may be patterned on top of the Si₃N₄ waveguides after the annealing process and prior to the planarization process. Various cavities or vias may be defined in the various layers of a given device such as by etching or other processes. The cavities may have electrode material such as metals or other conductors disposed therein in various embodiments.

In some embodiments, the electro-optical devices disclosed herein may include an electrode material, wherein the first encapsulation layer defines two or more channels / via , wherein the two or more channels / vias have electrode material disposed therein. In various embodiments, the electro-optical devices disclosed herein may include a removable substrate, wherein the first encapsulation layer is disposed on the removable substrate. In various fabrication and other methods disclosed herein, the methods may include comprising reducing erbium contamination from the erbium-doped Si₃N₄ waveguide amplifier by encapsulating the erbium-doped Si₃N₄ waveguide amplifier with SiO₂.

In various embodiments, undoped Si₃N₄ layers or waveguides are also annealed at temperatures between 800°C and 1,200°C. Low loss photonic devices may be formed by the undoped Si₃N₄ waveguides or layers (e.g., filters, resonators, etc.) In various embodiments the surface of the wafers may be planarized with chemical-mechanical polishing (CMP) to enable wafer-level oxide-to-oxide bonding. In some embodiments, the erbium-doped Si₃N₄ waveguide comprises a first Si₃N₄ layer and a second Si₃N₄ layer. The first Si₃N₄ layer may be doped with erbium and second layer is undoped.

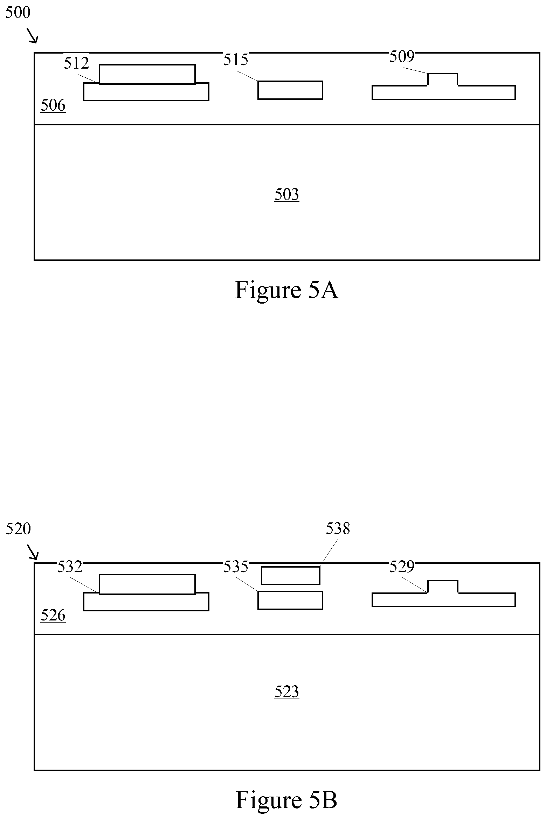

Refer now to the example embodiments Figures 5A-5D. Figures 5A-5D show example structures of the silicon photonic wafer prior to integration of the erbium-doped Si₃N₄ waveguide amplifier. Figure 5A depicts the silicon photonic wafer 500 with active photonic devices in a SiO₂ region 506 on a substrate 503. The active photonic devices may include for example, a modulator 509, a detector 512, and a silicon waveguide 515. In various embodiments the active photonic devices may also include a thermal-optic heater. The modulator 509 may be a silicon modulator and may include a doping. The detector 512 may be a germanium detector and may include doping. In various embodiments, the modulator 509 and detector 512 are configured to act as part of a transceiver. Some methods of fabricating the electro-optical devices may include providing a silicon photonic base wafer that includes a silicon substrate, an active photonic device; a waveguide; and a modulator; flip bonding an erbium-doped Si₃N₄ wafer to the silicon photonic base wafer, the erbium-doped Si₃N₄ wafer including an erbium-doped Si₃N₄ waveguide amplifier and a silicon substrate; and removing the silicon substrate of the erbium-doped Si₃N₄ wafer. The method may also include annealing the erbium-doped Si3N4 waveguide amplifier at a temperature that is greater than about 800°C.

In various embodiments as depicted in Figure 5B, a silicon photonic wafer 520 may include an Si₃N₄ waveguide 538 or layer in addition to a modulator 529, a detector 532, and a silicon waveguide 535 in the SiO₂ region 526 on a substrate 523. Such unannealed Si₃N₄ 538 waveguides do not have desirable low loss (1-2 dB/cm) but can be used for short distance routing and for assisting optical transition between silicon waveguides and the annealed and/or erbium-doped Si₃N₄ waveguide amplifier after integration. The Si₃N₄ waveguide 538 may include multiple layers. The loss associated with unannealed Si₃N₄ waveguides is manageable if the unannealed Si₃N₄ waveguide is with a length limit. In the context of the unannealed Si₃N₄ waveguide and other waveguides the length limit ranges from about 100 µm to about 5 cm. The Si₃N₄ waveguide 538 may be coupled to the silicon waveguide 535.

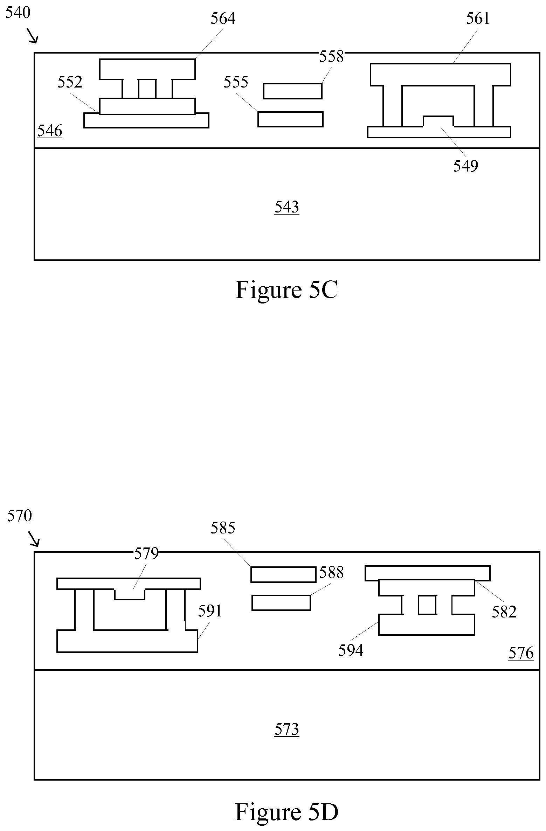

In various embodiments as depicted in Figure 5C, a silicon photonic wafer 540 may include metallization on the active devices. For example, a modulator 549 and a detector 552 may include metal contacts 561, 564. Various embodiments may also include a silicon waveguide 555 and an unannealed Si₃N₄ waveguide 558 in the SiO₂ region 546 on a substrate 543.

In various embodiments as depicted in Figure 5D, a silicon photonic wafer 570 is configured to be transferred to another silicon substrate by wafer bonding and substrate removal. Such silicon photonic wafer 570 includes elements in the appropriate orientation to be transferred to another silicon substrate. The silicon photonic wafer 570 may include a modulator 579 and a detector 582 which may include metal contacts 591, 594, a silicon waveguide 585, and an unannealed Si₃N₄ waveguide 588 in the SiO₂ region 576 on a silicon substrate 573. In various embodiments the silicon photonic wafer may be a monolithic CMOS-silicon photonic wafer with both electronic circuit and photonics integrated on the same wafer. In various embodiments the wafer surface is planarized with CMP to enable wafer bonding.

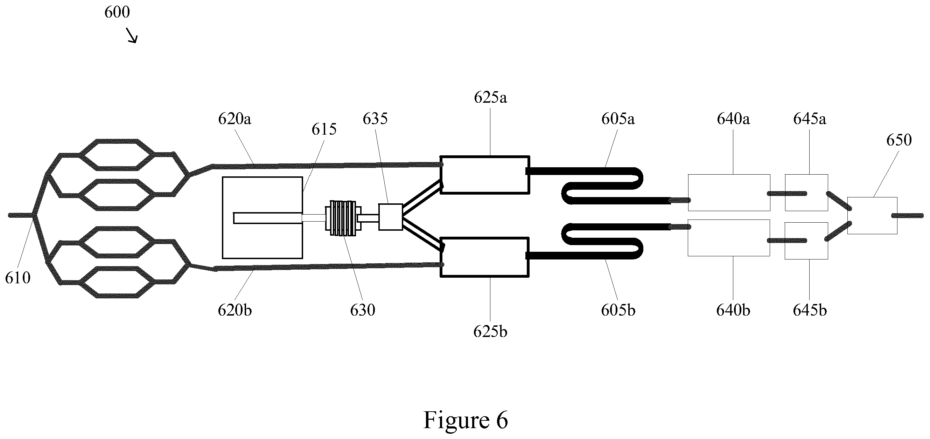

Refer now to the example embodiment of Figure 6. Figure 6 depicts a coherent transmitter 600 that may be implemented as part of a photonic integrated circuit (PIC). The coherent transmitter 600 may be with integrated erbium-doped Si₃N₄ waveguide amplifier 605a, 605b as described in the present disclosure. The signal outputs of silicon nested MZI modulators 610 are amplified by the erbium-doped Si₃N₄ waveguide amplifier amplifiers 605a, 605b with an integrated pump laser 615. The pump laser 615 may be flip-chip bonded to a trench in the silicon photonic chip using passive alignment. The bonding material can be solder, an AuSn alloy or other flip-chip bonding materials. The pump laser is shared by the two polarization paths 620a, 620b of the silicon nested MZI modulators 610.

In various embodiments, wavelength division multiplexer (WDM) coupler 625a, 625b combine the signal light at certain wavelength ranges. In various, the WDM coupler 625a, 625b may combine the signal light near 1550 nm and the pump light near 980 nm or 1480 nm, which is stabilized by a grating 630. The grating, splitter 635, and WDM coupler 625a, 625b are formed in undoped Si₃N₄ waveguides, in either the silicon photonic wafer or the Si₃N₄ wafer prior to wafer bonding. The combined signal and pump light is coupled to the erbium-doped Si₃N₄ waveguides and amplified 605a, 605b. After amplification, the light is coupled back to the silicon waveguides, filtered with tunable filters 640a, 640b to remove amplifier spontaneous emission (ASE) noise, attenuated with variable optical attenuators (VOAs) 645a, 645b to adjust the power, and combined with a polarization beam splitter and rotator (PBSR) 650. In some embodiments, the WDM coupler may also be configured as a combiner. The WDM coupler may be configured to combine light at about a first wavelength range and pump light at about a second wavelength range.

Although, the disclosure relates to different aspects and embodiments, it is understood that the different aspects and embodiments disclosed herein can be integrated, combined, or used together as a combination system, or in part, as separate components, devices, and systems, as appropriate. Thus, each embodiment disclosed herein can be incorporated in each of the aspects to varying degrees as appropriate for a given implementation. Further, the various apparatus, optical elements, coatings / layers, optical paths, waveguides, splitters, a variable optical attenuator, tunable filters, couplers, combiners, a coherent transmitter, electro-optical devices, inputs, outputs, ports, channels, components and parts of the foregoing disclosed herein can be used with any laser, laser-based communication system, waveguide, fiber, transmitter, transceiver, receiver, and other devices and systems without limitation.

Having thus described several aspects and embodiments of the technology of this application, it is to be appreciated that various alterations, modifications, and improvements will readily occur to those of ordinary skill in the art. Such alterations, modifications, and improvements are intended to be within the spirit and scope of the technology described in the application. It is, therefore, to be understood that the foregoing embodiments are presented by way of example only and that, within the scope of the appended claims and equivalents thereto, inventive embodiments may be practiced otherwise than as specifically described. **In** addition, any combination of two or more features, systems, articles, materials, and/or methods described herein, if such features, systems, articles, materials, and/or methods are not mutually inconsistent, is included within the scope of the present disclosure.

In most embodiments, a processor may be a physical or virtual processor. In other embodiments, a virtual processor may be spread across one or more portions of one or more physical processors. In certain embodiments, one or more of the embodiments described herein may be embodied in hardware such as a Digital Signal Processor (DSP). In certain embodiments, one or more of the embodiments herein may be executed on a DSP. One or more of the embodiments herein may be programmed into a DSP. In some embodiments, a DSP may have one or more processors and one or more memories. In certain embodiments, a DSP may have one or more computer readable storages. In many embodiments, a DSP may be a custom designed ASIC chip. In other embodiments, one or more of the embodiments stored on a computer readable medium may be loaded into a processor and executed.

Also, as described, some aspects may be embodied as one or more methods. The acts performed as part of the method may be ordered in any suitable way. Accordingly, embodiments may be constructed in which acts are performed in an order different than illustrated, which may include performing some acts simultaneously, even though shown as sequential acts in illustrative embodiments.

The phrase "and/or," as used herein in the specification and in the claims, should be understood to mean "either or both" of the elements so conjoined, i.e., elements that are conjunctively present in some cases and disjunctively present in other cases.

As used herein in the specification and in the claims, the phrase "at least one," in reference to a list of one or more elements, should be understood to mean at least one element selected from any one or more of the elements in the list of elements, but not necessarily including at least one of each and every element specifically listed within the list of elements and not excluding any combinations of elements in the list of elements. This definition also allows that elements may optionally be present other than the elements specifically identified within the list of elements to which the phrase "at least one" refers, whether related or unrelated to those elements specifically identified.

The terms "substantially" and "approximately" and "about" may be used to mean within ±20% of a target value in some embodiments, within ±10% of a target value in some embodiments, within ±5% of a target value in some embodiments, and yet within ±2% of a target value in some embodiments. The terms "substantially" and "approximately" and "about" may include the target value.

In the claims, as well as in the specification above, all transitional phrases such as "comprising," "including," "carrying," "having," "containing," "involving," "holding," "composed of," and the like are to be understood to be open-ended, i.e., to mean including but not limited to. The transitional phrases "consisting of" and "consisting essentially of" shall be closed or semi-closed transitional phrases, respectively.

Where a range or list of values is provided, each intervening value between the upper and lower limits of that range or list of values is individually contemplated and is encompassed within the disclosure as if each value were specifically enumerated herein. In addition, smaller ranges between and including the upper and lower limits of a given range are contemplated and encompassed within the disclosure. The listing of exemplary values or ranges is not a disclaimer of other values or ranges between and including the upper and lower limits of a given range.

The use of headings and sections in the application is not meant to limit the disclosure; each section can apply to any aspect, embodiment, or feature of the disclosure. Only those claims which use the words "means for" are intended to be interpreted under 35 USC 112, sixth paragraph. Absent a recital of "means for" in the claims, such claims should not be construed under 35 USC 112. Limitations from the specification are not intended to be read into any claims, unless such limitations are expressly included in the claims.

Embodiments disclosed herein may be embodied as a system, method or computer program product. Accordingly, embodiments may take the form of an entirely hardware embodiment, an entirely software embodiment (including firmware, resident software, microcode, etc.) or an embodiment combining software and hardware aspects that may all generally be referred to herein as a "circuit," "module," or "system." Furthermore, embodiments may take the form of a computer program product embodied in one or more computer readable medium(s) having computer readable program code embodied thereon.

## Claims

1. An electro-optical device comprising:
an optical amplifier comprising:
a first encapsulation layer defining a first bonding surface, and
an erbium-doped Si₃N₄ waveguide, wherein the erbium-doped Si₃N₄ waveguide disposed within the first encapsulation layer;
wherein the electro optical device further comprises:
a photonic assembly comprising:
a substrate,
a second encapsulation layer defining a second bonding surface, the second encapsulation layer disposed on the substrate,
a modulator,
one or more photodetectors, and
a waveguide,
wherein the modulator, the one or more photodetectors and the waveguide are disposed within the second encapsulation layer, wherein one or more regions of the first bonding surface are bonded to the one or more regions of the second bonding surface,
wherein the erbium-doped Si₃N₄ waveguide is optically coupled to the waveguide.

2. The electro-optical device of claim 1, further comprising a removable substrate, wherein the first encapsulation layer is disposed on the removable substrate.

3. The electro-optical device of any preceding claim, wherein the optical amplifier is annealed at a temperature that is greater than about 800°C.

4. The electro-optical device of any preceding claim, wherein the first encapsulation layer comprises SiO₂, optionally wherein the erbium-doped Si3N4 waveguide comprises a first Si₃N₄ layer and a second Si₃N₄ layer, wherein the first Si₃N₄ layer is doped with erbium and second layer is undoped.

5. The electro-optical device of any preceding claim, wherein the waveguide is a Si₃N₄ waveguide, wherein the photonic assembly further comprise a silicon waveguide, wherein the erbium-doped Si3N4 waveguide is optically coupled to the Si₃N₄ waveguide and the Si₃N₄ waveguide is optically coupled to the silicon waveguide.

6. The electro-optical device of any preceding claim, further comprising a laser, wherein at least a portion of the laser is disposed in a cavity, the cavity defined in the first encapsulation layer and the second encapsulation layer, the laser in optical communication with the waveguide, wherein the waveguide is a Si₃N₄ waveguide.

7. The electro-optical device of claim 6 further comprising a wavelength division multiplexer, WDM, coupler in optical communication with the Si₃N₄ waveguide, wherein the WDM coupler is configured to combine light at about a first wavelength range and pump light at about a second wavelength range.

8. The electro-optical device of claim 6 or 7, wherein the photonic assembly further comprises a wavelength-stabilization device comprising a wavelength-selective partial reflector and an optical delay element.

9. The electro-optical device of any preceding claim, further comprising a photonic integrated circuit comprising a coherent transmitter, wherein the optical amplifier and the photonic assembly are integrated into the photonic integrated circuit, the photonic integrated circuit further comprising an element selected from the group consisting of: a plurality of silicon nested MZI modulators, a pump laser, a grating, a splitter, a WDM coupler, a tunable filter, a variable optical attenuator, and a polarization beam splitter and rotator.

10. A method of integrating an erbium-doped Si₃N₄ waveguide amplifier with photonic assembly, the method comprising:
providing a silicon photonic base wafer comprising an active photonic device; a waveguide; and a modulator,
flip bonding an erbium-doped Si₃N₄ wafer to the silicon photonic base wafer, the erbium-doped Si₃N₄ wafer including an erbium-doped Si₃N₄ waveguide amplifier and a silicon substrate; and
removing the silicon substrate of the erbium-doped Si₃N₄ wafer.

11. The method of claim 10, further comprising annealing the erbium-doped Si₃N₄ waveguide amplifier at a temperature that is greater than about 800°C.

12. The method of claim 10 or 11, wherein the erbium-doped Si₃N₄ wafer and the silicon photonic base wafer are bonded using oxide-to-oxide direct bonding, optionally wherein the erbium-doped Si₃N₄ wafer and the silicon photonic base wafer are bonded at a temperature less than about 400°C.

13. The method of any of claims 10 to 12, wherein the erbium-doped Si₃N₄ waveguide amplifier is encapsulated by SiO₂.

14. A method of integrating an erbium-doped Si₃N₄ waveguide amplifier with photonic assembly, the method comprising:
providing an erbium-doped Si₃N₄ base wafer including an erbium-doped Si₃N₄ waveguide amplifier;
flip bonding a silicon photonic wafer to the erbium-doped Si₃N₄ base wafer, the silicon photonic wafer including a silicon substrate, an active photonic device; a waveguide; and a modulator; and
removing the silicon substrate of the silicon photonic wafer by mechanical grinding and dry etching or wet etching.

15. The method of claim 14, wherein any one or more of:
A) the method further comprises annealing the erbium-doped Si₃N₄ waveguide amplifier at a temperature that ranges between about 800°C and about 1200°C;
B) the erbium-doped Si₃N₄ base wafer and the silicon photonic wafer are bonded using oxide-to-oxide direct bonding;
C) the erbium-doped Si₃N₄ base wafer and the silicon photonic wafer are bonded at a temperature less than about 400°C;
D) the method further comprises reducing erbium contamination from the erbium-doped Si₃N₄ waveguide amplifier by encapsulating the erbium-doped Si₃N₄ waveguide amplifier with SiO₂.
